(19)

**Europäisches Patentamt**
**European Patent Office**
**Office européen des brevets**

(11) **EP 3 555 602 B1**

(12) **FASCICULE DE BREVET EUROPEEN**

(45) Date de publication et mention
de la délivrance du brevet:
**12.04.2023 Bulletin 2023/15**

(21) Numéro de dépôt: **17817719.2**

(22) Date de dépôt: **12.12.2017**

(51) Classification Internationale des Brevets (IPC):
**G01N 23/2251** (2018.01)    **G03F 7/20** (2006.01)

(52) Classification Coopérative des Brevets (CPC):
**G01N 23/2251; G03F 7/70625;** G01N 2223/401;
G01N 2223/418; G01N 2223/611;
H01J 2237/24578; H01J 2237/2816;
H01J 2237/2817

(86) Numéro de dépôt international:
**PCT/EP2017/082429**

(87) Numéro de publication internationale:
**WO 2018/108914 (21.06.2018 Gazette 2018/25)**

(54) **PROCEDE DE CARACTERISATION PAR MICROSCOPIE ELECTRONIQUE A BALAYAGE CDSEM**

VERFAHREN ZUR CHARAKTERISIERUNG DURCH
CD-SEM-RASTERELEKTRONENMIKROSKOPIE

METHOD FOR CHARACTERISATION BY CD-SEM SCANNING ELECTRON MICROSCOPY

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **15.12.2016 FR 1662505**

(43) Date de publication de la demande:
**23.10.2019 Bulletin 2019/43**

(73) Titulaire: **Commissariat à l'Énergie Atomique
et aux Énergies Alternatives
75015 Paris (FR)**

(72) Inventeurs:
• **QUEMERE, Patrick
38340 Voreppe (FR)**
• **HAZART, Jérôme
38320 Eybens (FR)**

(74) Mandataire: **Cabinet Camus Lebkiri
25 rue de Maubeuge
75009 Paris (FR)**

(56) Documents cités:
**JP-A- 2014 041 058    US-A1- 2003 071 213**

• **BABIN S ET AL: "Fast analytical modeling of SEM images at a high level of accuracy",
OPTOMECHATRONIC MICRO/NANO DEVICES AND COMPONENTS III : 8 - 10 OCTOBER 2007, LAUSANNE, SWITZERLAND; [PROCEEDINGS OF SPIE , ISSN 0277-786X], SPIE, BELLINGHAM, WASH, vol. 9424, 19 mars 2015 (2015-03-19), pages 94240I-94240I, XP060051658, DOI: 10.1117/12.2086072 ISBN: 978-1-62841-730-2**
• **MACK CHRIS A ET AL: "Improvements to the analytical linescan model for SEM metrology", SPIE - INTERNATIONAL SOCIETY FOR OPTICAL ENGINEERING. PROCEEDINGS, S P I E - INTERNATIONAL SOCIETY FOR OPTICAL ENGINEERING, US, vol. 9778, 18 mars 2016 (2016-03-18), pages 97780A-97780A, XP060065251, ISSN: 0277-786X, DOI: 10.1117/12.2218443 ISBN: 978-1-5106-0753-8**

**Description**

**DOMAINE DE l'INVENTION**

Le domaine de l'invention concerne un procédé de mise en oeuvre d'une technique de caractérisation par microscopie électronique à balayage (Scanning Electron Microscopy ou SEM en anglais). A cet effet, l'invention porte sur des applications en métrologie dimensionnelle notamment pour l'industrie du semiconducteur. Le domaine de l'invention concerne aussi la détermination d'une dimension critique (Critical dimension Scanning electron microscopy ou CDSEM en anglais) de la topographie d'un échantillon de semiconducteurs, par exemple un circuit imprimé en microélectronique.

**ETAT DE L'ART**

La caractérisation de structures de taille micrométrique ou nanométrique est aujourd'hui d'importance primordiale dans l'industrie des semiconducteurs, notamment en microélectronique, et plus généralement dans le domaine des nanotechnologies. Si l'on considère le cas de la microélectronique, la mesure précise et fiable des dimensions caractéristiques des nanostructures se rend nécessaire tout au long des différentes étapes du processus de production, à partir de la phase de recherche et développement jusqu'à la phase de production. De plus, la miniaturisation des composantes microélectroniques demande des outils de caractérisation toujours plus performants.

L'industrie des semiconducteurs définit la taille de ses produits en termes d'une taille caractéristique appelée dimension critique ou « critical dimension » (CD) en anglais. On entend par dimension critique la ou les dimensions critiques d'un motif représentant une ou plusieurs longueurs caractéristiques du motif qui s'avèrent critiques soit pour la maitrise du procédé de fabrication soit pour garantir les performances électriques du dispositif électronique final constitué desdits motifs. La mesure fiable de cette dimension critique est aujourd'hui l'un des enjeux principaux pour la microscopie électronique à balayage.

Lors de l'acquisition d'une image par microscopie électronique à balayage, un faisceau d'électrons, dit faisceau d'électrons primaires, balaye la surface d'un échantillon d'intérêt. Chaque point de la surface est identifié par un couple de cordonnées spatiales appelées (x,y) dans la suite. Les collisions entre électrons primaires et les atomes de l'échantillon produisent plusieurs phénomènes physiques qui peuvent être très complexes. Parmi ces phénomènes il y a l'émission d'électrons secondaires et l'émission d'électrons rétrodiffusés. Ces électrons sont captés par des détecteurs sélectifs à proximité de l'échantillon. En balayant point par point l'échantillon on parvient à la formation d'une image électronique reflétant les différentes formes et différents matériaux de l'échantillon. Dans ce qui suit on se référera aux différentes formes de l'échantillon et leurs différents matériaux comme à la structure de l'échantillon.

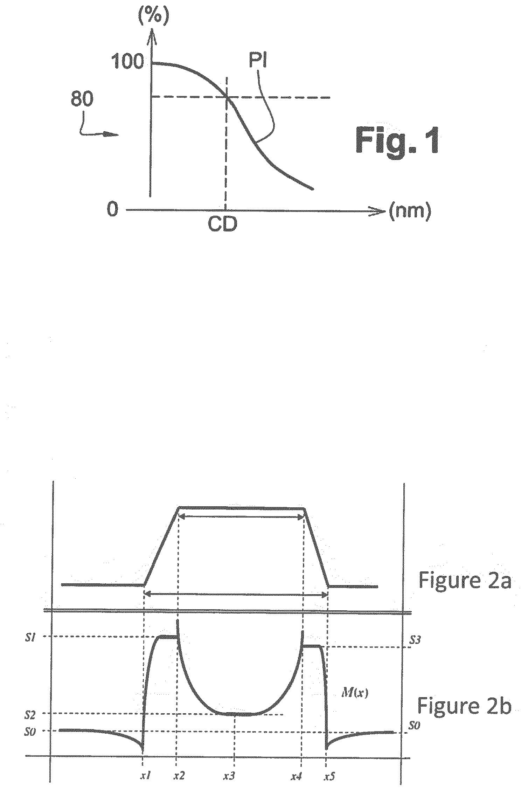

L'image SEM ainsi obtenue est une image en niveau de gris et les mesures géométriques des objets sont déterminées par une analyse des contours des objets obtenus après le choix d'un ou plusieurs seuils par exemple. On peut par exemple reconstruire un graphique comme illustré sur la figure 1 représentant un profil d'intensité d'électrons secondaires PI comportant en ordonnées un pourcentage d'électrons secondaires recueillis et en abscisse une dimension en nm représentative de la position de balayage. Mais un des problèmes majeurs est l'interprétation des images par des algorithmes à seuillage : c'est en effet le choix de ce seuil qui va déterminer la valeur de la taille caractéristique, ou dimension critique, d'intérêt. Or le choix du seuil est souvent arbitraire et le choix optimal est différent pour chaque objet, notamment en fonction de la hauteur des motifs, des matériaux en jeu, des dimensions des objets, de la densité de motifs, etc. D'autres types d'algorithmes sont basés non pas directement sur le niveau de gris mais sur l'analyse de la forme des pics d'intensité et le choix d'un seuil relatif à l'amplitude des pics. Là encore, le choix du seuil relatif à l'analyse du pic est empirique. Actuellement il est connu que les techniques CD-SEM donnent des mesures peu fiables pour des objets de taille inférieure à 100 nm (écart à la réalité du nanomètre à plusieurs nanomètres). Un seuil fixe empirique appliqué à tout type de motif est d'autant moins satisfaisant qu'il n'y a aucun lien physique direct entre le pourcentage d'électrons secondaires recueillis et la hauteur réelle du motif à laquelle on cherche à déterminer la dimension critique. En d'autres termes, si une mesure à 80% d'électrons secondaires est réalisée, ce n'est pas pour autant que l'on mesure une dimension critique à 80% de la hauteur du motif. Une analyse des images SEM avec un algorithme de seuillage peut donc très facilement fausser les mesures des dimensions critiques.

Pour remédier ce problème, deux approches ont été envisagées. La première est basée sur des simulations physiques de type Monte Carlo. La mise en oeuvre de cette méthode requiert la simulation des processus physiques d'interaction entre les électrons primaires du faisceau incident sur l'échantillon et l'échantillon luimême. La réalisation de ces simulations très complexes demande une grande puissance de calcul et des temps d'exécution très longs. Ces caractéristiques rendent les simulations physiques de type Monte Carlo généralement peu accessibles et très peu adaptées au traitement d'un grand nombre d'images CDSEM. La seconde solution consiste à réaliser une modélisation mathématique paramétrique des images ; une telle solution est notamment décrite dans l'article « CD characterization of nanostructures in SEM metrology » (C. G. Frase, E. Buhr, et K. Dirscherl, Meas. Sci. Technol., vol. 18, n° 2, p. 510, février. 2007). Un exemple de telles fonctions est illustré en figure 2b pour un motif ayant un profil selon la direction x trapézoïdale, représenté en figure 2a. Ces fonctions peuvent être choisies selon un modèle phénoménologique simple ou bien par l'analyse de modélisations Monte-Carlo préliminaires décrivant la formation des images SEM (plus complexes et précises mais nécessitant des temps de calcul longs). Selon l'exemple de la figure 2, le motif est décomposé suivant des sections selon la direction x (ici six sections), chaque section correspondant à une fonction de forme particulière. La fonction M(x) peut ainsi se décomposer comme suit (en six fonctions selon chacune des sections) :

$$
M(x) := \begin{cases}
S0 + Ae^{\frac{x-x1}{t0}} & x < x1 \\
S1 - (S1 - S0 - A)e^{-\frac{x-x1}{t1}} & x1 \le x \le x2 \\
S2 + Ce^{\frac{x-x2}{t2}} & x2 < x \le x3 \\
S2 + De^{\frac{x-x4}{t3}} & x3 < x < x4 \\
S3 - (S3 - S0 - B)e^{\frac{x-x5}{t4}} & x4 \le x \le x5 \\
S0 + Be^{\frac{x5-x}{t5}} & x > x5
\end{cases}
$$

Chacune des six fonctions paramétriques reproduit la hauteur du profil de l'échantillon en fonction de la cordonnée x dans une certaine gamme de valeurs de x. Le modèle présenté ci-dessus comporte donc une pluralité de paramètres : $x_1$, $x_2$, $x_3$, $x_4$, $x_5$, $S_0$, $S_1$, $S_2$, $S_3$, $t_0$, $t_1$, $t_2$, $t_3$, $t_4$, $t_5$, A, B, C, D. L'existence de ce jeu de paramètres justifie l'appellation de fonction mathématique paramétrique. Souvent, pour des applications en métrologie dimensionnelle, les paramètres les plus intéressants sont ceux relatifs aux dimensions latérales du motif à savoir : $x_1$, $x_2$, $x_4$ et X5.

Une autre méthode de modélisation paramétrique des images CD-SEM est décrite dans l'article « Analytical Linescan Model for SEM Metrology » (C. A. Mack et B.D. Bunday, Metrology, Inspection and Process Control for Microlitography XXIX, Proc. SPIE Vol. 9424 2015). Selon ce modèle la fonction $M(x)$ peut se décomposer comme suit :

$$
M(x) := \begin{cases}
S0.\left(1 - \alpha_f.e^{\frac{x}{\sigma_f}} - \alpha_b.e^{\frac{x}{\sigma_b}}\right) & x < x1 \\
S1 + \left(S0.\left(1 - \alpha_f - \alpha_b\right) - S1\right).e^{\frac{x}{d1}} + \left(S2.\left(1 + \alpha_e - \alpha_v\right) - S1\right).e^{\frac{(X2-x)}{d2}} & x1 \le x \le x2 \\
S2 * \left(1 + \alpha_e.e^{\frac{X2-x}{\sigma_e}} - \alpha_v.e^{\frac{X2-x}{\sigma_v}}\right) & x > x2
\end{cases}
$$

Dans ce modèle les paramètres sont $S_0$, $S_1$, $S_2$, $\alpha_f$, $\alpha_b$, $\alpha_e$, $\alpha_v$, $\sigma_f$, $\sigma_b$, $\sigma_e$, $\sigma_v$, $d_1$, $d_2$, $X_2$.

De plus, pour tenir compte de la taille du faisceau d'électrons primaires, qui n'est pas nulle, il convient d'associer au profil décrit par $M(x)$ un produit de convolution incluant dans le modèle les paramètres décrivant la taille et la forme du faisceau. Le plus souvent le profil du faisceau d'électrons primaires est caractérisé à l'aide d'un profil gaussien (« point spread fonction » ou PSF en anglais), le paramètre $\sigma_{PSF}$ étant proportionnel à la largeur à mi-hauteur de la gaussienne. Le modèle paramétrique ainsi modifié est calculé à l'aide de la formule suivante :

$$
M(x) = \iint_{-\infty}^{+\infty} e^{-\frac{(x-x')^2}{2\sigma_{PSF}^2}} * M(x')dx'
$$

Dans la suite l'expression « jeu de paramètres du modèle théorique » se référera à l'ensemble des paramètres utilisés dans la formulation mathématique du modèle théorique. Parmi ces paramètres, certains sont utilisés dans la description géométrique de la structure de l'échantillon, d'autres décrivent la réponse instrumentale. Une fonction paramétrique telle que la fonction $M(x)$ sera appelée dans la suite profil modèle ou profil paramétrique.

Un autre type de modélisation consiste à modéliser la probabilité d'émission d'un électron secondaire en fonction du matériau et la propagation de ces électrons vers les détecteurs en fonction de l'angle des détecteurs (voir publication SEM Simulation for 2D and 3D Inspection Metrology and Defect Review de Shimon Levia, Ishai Schwarzbanda, Sergey Khristoa, Yan Ivanchenkoa, Ofer Adana, PDC business group, Applied Materials, Rehovot 76705, Israel).

Des modèles plus simples ou plus complexes peuvent être élaborés en fonction du type d'échantillon, de la qualité des images, ou bien des informations a priori sur les matériaux ou les profils.

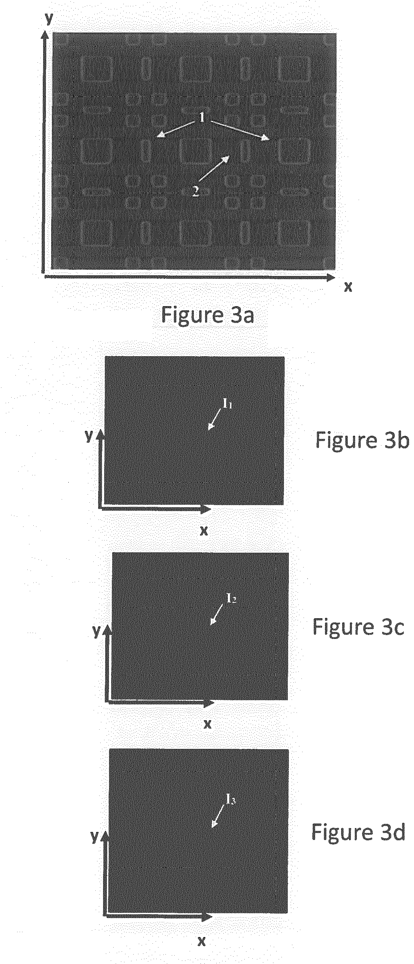

Une fois la modélisation terminée, il faut résoudre un problème inverse, à savoir l'ajustement des données expérimentales au modèle en faisant varier les paramètres. Une des limitations majeures de ces techniques est dans leur incapacité à prendre en compte et à reproduire certains artefacts observés sur les images CDSEM. C'est par exemple le cas des images acquises en mode de balayage dit TV (ou « raster scan » en anglais). Ces images montrent des marques sombres dans les régions de la surface de l'échantillon comprises entre deux ou plusieurs structures voisines, comme les plots carrés ou rectangulaires de la figure 3a. Sur cette figure des directions x et y sont indiquées, la direction x étant celle de balayage et la direction y étant perpendiculaire à la direction x. Plus précisément ces marques sombres peuvent être classées suivant deux types :

- des marques plutôt linéaires en gris foncé ou en noir dans le prolongement des arêtes horizontales alignées avec la direction de balayage et indiquées par le repère 1 de la figure 3a
- des marques surfaciques en gris moins foncé le long des motifs, toujours dans la direction de balayage et indiquées par le repère 2 de la figure 3a.

Ces marques sombres sont des artefacts créés pendant le processus de formation de l'image.

On peut remarquer que la méthode des profils paramétriques ne rend compte que d'une modélisation des profils suivant la direction perpendiculaire aux arêtes et n'est donc pas en mesure de reproduire les effets de trainées noires présentes dans le prolongement des arêtes mêmes. Il est intéressant de noter que, comme illustré sur les figures 3b, 3c et 3d, la présence des trainées noires augmente quand plusieurs structures rapprochées sont présentes. Plus précisément, la figure 3b montre une structure carrée isolée. Des traces sombres sont visibles à gauche et à droite de la structure, indiquées par le repère $I_1$, avec des trainées noires dans le prolongement des arêtes horizontales. La figure 3c montre une image SEM de trois structures carrées rapprochées et alignées suivant la direction horizontale. Les marques sombres, indiquées par $I_2$, sont plus intenses que sur la figure 3b. La figure 3d montre une image SEM d'une série de plusieurs structures carrées. Les artéfacts de type marques sombres selon la direction de balayage, indiquées par $I_3$, sont cette fois plus intenses que sur les images 3b et 3c. Ces altérations ne peuvent pas être décrites suivant une vision purement locale comme celle des profils paramétriques.

De plus, la méthode des profils paramétriques ne prend pas en compte les effets liés à l'accumulation de charges électriques déposées par le faisceau d'électrons primaires lors du balayage. Ces charges en excès peuvent dévier les électrons mesurés par les détecteurs sélectifs à proximité de l'échantillon, ce qui comporte l'apparition d'artefacts dans les images expérimentales.

Une méthode pour corriger des effets dus à l'accumulation de charges sur l'échantillon est décrit dans JP2014041058.

Par ailleurs, le chargement en électrons de la matière lors de l'exposition au faisceau d'électrons primaires n'est pas constant dans le temps. Au contraire la charge en excès peut diminuer au cours du temps à cause des processus dits d'évacuation des charges. La dépendance temporelle des phénomènes de charging complique le traitement des images CD-SEM pour l'élimination de ces artefacts.

## PROBLEME TECHNIQUE

Dans ce contexte, la présente invention a pour but d'améliorer l'exploitation des images CD-SEM obtenues expérimentalement par une technique CDSEM paramétrique, notamment en prenant en compte à la fois les effets de « charging » spatial et ceux de « charging » temporel.

## RESUME DE L'INVENTION

A cette fin, un objet de l'invention est un procédé de mise en oeuvre d'une technique de caractérisation par microscopie électronique à balayage pour la détermination d'au moins une dimension critique de la structure d'un échantillon dans le domaine de la métrologie dimensionnelle, dite technique CD-SEM, ledit procédé comportant les étapes suivantes :

- réalisation d'une image expérimentale représentative de la structure de l'échantillon et issue d'un microscope électronique à balayage ;
- à partir d'un premier modèle théorique basé sur des fonctions mathématiques paramétriques, calcul d'un second modèle théorique $U(P_i, t_i)$ décrivant un signal mesuré lors de la réalisation de ladite image, le signal étant mesuré par un détecteur du microscope, à l'instant $t_i$, lorsqu'un faisceau d'électrons primaires éclaire la position $P_i$, ledit second modèle $U(P_i, t_i)$ étant obtenu par somme algébrique d'un terme correctif $S(P_i, t_i)$, ledit second modèle

théorique étant paramétré par un jeu de paramètres à déterminer, le premier et second modèle théorique étant chacun une représentation mathématique de la structure de l'échantillon dans l'image expérimentale;

- détermination du jeu de paramètres présents dans le second modèle théorique au moyen d'un ajustement entre ledit second modèle théorique et ladite image expérimentale ;

ledit procédé étant caractérisé en ce que ledit terme correctif $S(P_i, t_i)$ est calculé en sommant le signal provenant des charges électriques déposées par le faisceau d'électrons primaires lors d'une pluralité d'instants t inférieurs ou égaux à $t_i$, le terme correctif étant obtenu comme un produit de convolution entre le premier modèle paramétrique et un noyau de convolution donné, qui contient une fonction de dispersion temporelle et une fonction de dispersion spatiale.

On entend par dimension critique (« critical dimension » en anglais) la ou les dimensions critiques d'un motif représentant une ou plusieurs longueurs caractéristiques du motif qui s'avèrent critiques soit pour la maitrise du procédé de fabrication soit pour garantir les performances électriques du dispositif électronique final constitué desdits motifs.

On entend par modèle théorique basé sur des fonctions paramétriques mathématiques une représentation mathématique de la structure de l'échantillon, par exemple par une des fonctions M(x) définies précédemment et décrites en détail dans les articles « CD characterization of nanostructures in SEM metrology » (C. G. Frase, E. Buhr, et K. Dirscherl, Meas. Sci. Technol., vol. 18, n° 2, p. 510, février. 2007) ou « Analytical Linescan Model for SEM Metrology » (C. A. Mack et B.D. Bunday, Metrology, Inspection and Process Control for Microlitography XXIX, Proc. SPIE Vol. 9424 2015) ou AMAT par exemple.

On entend par jeu de paramètres présents dans le second modèle théorique l'ensemble des paramètres utilisés dans la formulation mathématique du second modèle théorique. Ce jeu de paramètres inclut à la fois les paramètres présents dans le premier modèle théorique paramétrique et les paramètres présents dans le terme correctif ajouté lors du calcul du second modèle théorique. Dans ce jeu de paramètres on aura certains paramètres décrivant la géométrie de la structure de l'échantillon, d'autres décrivant la réponse instrumentale.

On entend par ajustement entre le second modèle théorique et l'image expérimentale un procédé de calcul itératif visant à trouver le jeu de paramètres qui minimise l'écart entre ledit modèle et ladite image expérimentale. Dans la pratique, ce procédé de calcul est par exemple mis en oeuvre par calculateur en choisissant un des algorithmes connus pour minimiser l'écart entre l'image expérimentale et le modèle théorique, suivant par exemple la méthode dite des moindres carrées.

De façon générale, l'invention consiste à obtenir les dimensions critiques de la structure de l'échantillon au moyen d'un ajustement entre une image expérimentale représentative de la structure de l'échantillon et un modèle théorique, ledit modèle théorique étant calculé de façon à prendre en compte les artefacts présents sur les images expérimentales.

Le but de l'invention est l'obtention plus efficace et plus précise des dimensions critiques.

Le signal mesuré à la position $P_i$ correspond au signal enregistré dans le pixel $P_i$ du détecteur.

De plus, l'invention consiste à associer aux approches paramétriques un terme correctif temporel $S(P_i, t_i)$ qui tient compte du temps de passage du faisceau électronique lors du balayage de la surface de l'échantillon. Cela revient à prendre en compte le parcours du faisceau d'électrons primaires. Autrement dit, le terme correctif temporel $S(P_i, t_i)$ explicite la notion de causalité : le signal mesuré à la position $P_i$ à l'instant $t_i$ dépend du parcours du faisceau d'électrons primaires, c'est-à-dire des positions $P_j$ occupées aux instants t précédant l'instant $t_i$.

Le terme correctif $S(P_i, t_i)$ est obtenu en sommant le signal provenant des charges en excès présentes aux positions $P_j$ précédemment balayées par le faisceau d'électrons primaires. Chaque terme de la somme comprend une fonction de dispersion temporelle pour prendre en compte les mécanismes d'évacuation des charges et une fonction de dispersion spatiale pour prendre en compte la topographie de l'échantillon.

Autrement dit, le terme correctif $S(P_i, t_i)$ est obtenu comme un produit de convolution entre le premier modèle paramétrique et un noyau de convolution donné. Le produit de convolution est calculé sur les positions balayées par le faisceau d'électrons primaires avant d'arriver à la position $P_i$ à l'instant $t_i$.

La prise en compte des positions balayées par le faisceau avant d'arriver à la position $P_i$ permet d'introduire la notion de causalité dans le second modèle théorique. Grâce au noyau de convolution donné, qui contient une fonction de dispersion temporelle et une fonction de dispersion spatiale, les effets de charging temporel sont pris en compte. L'effet à la position $P_i$ de la charge déposée à la position $P_j$ dépend de la distance entre les deux positions mais aussi du temps qui s'est écoulé entre le passage du faisceau d'électrons primaires en $P_j$ et le passage en $P_i$.

Par exemple, si l'écart temporel entre l'instant $t_j$ auquel la charge a été déposée à la position $P_j$ et l'instant $t_i$ auquel le faisceau se trouve à la position $P_i$ est beaucoup plus grand que le temps caractéristique des mécanismes d'évacuation des charges, le second modèle théorique ne prend pas en compte l'effet de la charge à la position $P_j$.

Le procédé selon l'invention peut également présenter une ou plusieurs des caractéristiques ci-dessous, considérées individuellement ou selon toutes les combinaisons techniquement possibles :

- le second modèle théorique est calculé selon la formule suivante :

$$U(P_i, t_i) = \left[\sum_{j=1}^{i} Q_j R_j \delta(P_i - P_j)\right] - S(P_i, t_i)$$

dans laquelle :

$U(P_i, t_i)$ est le second modèle théorique calculé en correspondance de la position $P_i$ sur la surface de l'échantillon à l'instant $t_i$ ;

l'indice $j \le i$ balaye la séquence de positions $P_j$ du faisceau d'électrons primaires éclairées aux instants $t_j$, jusqu'à la position $P_i$ éclairée à l'instant $t_i$, le faisceau d'électrons primaires pouvant éclairer la même position à des instants différents ;

$Q_j$ est la charge électrique déposée par le faisceau d'électrons primaires lorsque le faisceau éclaire la position $P_j$ ;

$R_j$ est la fonction mathématique paramétrique contenant les paramètres décrivant la topographie de l'échantillon et le rendement de création de charge à la position $P_j$ ;

$\delta(P_i - P_j)$ est un delta de Kronecker, qui est égal à un quand $P_i = P_j$ et zéro ailleurs ;

$\sum_{j=1}^{i} Q_j R_j \delta(P_i - P_j)$ est le premier modèle théorique du signal mesuré à la position $P_i$ à l'instant $t_i$ et prend en compte la topographie de l'échantillon, la charge électrique déposée, le rendement de charge et les passages multiples du faisceau d'électrons primaires lors du balayage ;

$$S(P_i, t_i) = \sum_{j=1}^{i} \delta(P_i - P_j)\left[\sum_{k=1}^{j} C_k Q_k R_k F_S(P_j - P_k) F_t(t_j - t_k)\right]$$

est le terme correctif ;

$F_S(P_i - P_j)$ est une fonction de dispersion spatiale prenant en compte la distance entre la charge électrique à la position $P_j$ et la position $P_i$ ;

$F_t(t_i - t_j)$ est une fonction de dispersion temporelle prenant en compte l'écart temporel entre le dépôt de la charge électrique à la position $P_j$ à l'instant $t_j$ et la mesure du signal à la position $P_i$ à l'instant $t_i$ ;

$C_j$ est coefficient effectif d'accumulation de charges à la position $P_j$.

- le courant d'électrons primaires est constant et égale à $Q_0$, le faisceau d'électrons primaires éclaire chaque position $P_j$ une seule fois et le second modèle théorique est calculé selon la formule suivante :

$$U(P_i, t_i) = U_0(P_i, t_i) - Q_o \sum_{j=1}^{i} R_j C_j F_s(P_i - P_j). F_t(t_i - t_j)$$

dans laquelle $U_0(P_i, t_i) = Q_0 R_i$.

- la réponse de l'échantillon en absence de topographie est $R_0$ et l'intensité de fond $U_b(P_i, t_i)$ due à l'excès de charge est soustraite au second modèle théorique pour éliminer l'émission des régions non structurées de l'échantillon, l'intensité de fond étant calculée selon la formule suivante

$$U(P_i, t_i) - U_b(P_i, t_i) = Q_0 \left( R_i - R_0 - \sum_{j=1}^{i} (R_j C_j - R_0 C_0) F_s(P_i - P_j). F_t(t_i - t_j) \right)$$

Dans laquelle $U_b(P_i, t_i) = Q_0 R_0 \left[1 - \sum_{j=1}^{i} C_j F_S(P_i - P_j) F_T(t_i - t_j)\right]$.

- le faisceau d'électrons primaires balaye la surface de l'échantillon suivant la méthode de balayage dite TV ou « raster scan » en anglais, la direction de balayage étant la direction horizontale ou axe x, la vitesse de balayage $v_x$ étant constante, le second modèle théorique est calculé selon la formule suivante :

$$U(x) - U_b(x) \propto \left[ R(x) - R_0 - \int_0^x (C(x')R(x') - C_0R_0)v_x F(x - x')dx' \right]$$

dans laquelle :

x est la cordonnée spatiale dans la direction de balayage du faisceau d'électrons primaires ;

$U_b(x)$ est l'intensité de fond à la position x ;

$Q_0(x)$ est la charge déposée par le faisceau d'électrons primaires en correspondance de la position x ;

$F(x - x') = F_S(x - x')F_t\left(\frac{x-x'}{v_x}\right)$ contient la fonction de dispersion spatiale et la fonction de dispersion temporelle exprimée en fonction de la cordonné x, la vitesse de balayage $v_x$ étant constante.

- la fonction de dispersion temporelle est une fonction exponentielle avec constante de temps $\tau$ :

$$F_t(t) = e^{-\frac{t}{\tau}}$$

- la fonction de dispersion temporelle est une fonction de type distribution de Cauchy :

$$F_t(t) = \frac{1}{1 + \left(\frac{t}{\tau}\right)^2}$$

- la fonction de dispersion spatiale est de la forme

$$F_S(r) = e^{-\frac{\|r\|^2}{2\sigma^2}}$$

Un autre objet de l'invention est un procédé de calibration d'une technique de caractérisation CD-SEM, ladite calibration comportant les étapes suivantes :

- réalisation d'une image expérimentale représentative de la structure d'un échantillon de référence dont les dimensions géométriques sont connues, ladite image étant issue d'un microscope électronique à balayage
- à partir d'un premier modèle théorique basé sur des fonctions mathématiques paramétriques, calcul d'un second modèle théorique obtenu par somme algébrique d'un terme correctif, ledit second modèle théorique comportant un jeu de paramètres, ledit jeu de paramètres comprenant à la fois les paramètres connus qui décrivent la structure géométrique de l'échantillon de référence et les paramètres à déterminer qui décrivent la réponse instrumentale ;
- détermination des paramètres présents dans le second modèle théorique et décrivant la réponse instrumentale au moyen d'un ajustement entre ledit second modèle théorique et ladite image expérimentale représentative de la structure de l'échantillon de référence.

Un autre objet de l'invention est la mise en oeuvre d'une technique CD-SEM calibrée, ledit procédé comportant les étapes suivantes :

- réalisation d'une image expérimentale représentative de la structure de l'échantillon et issue d'un microscope électronique à balayage ;
- à partir d'un premier modèle théorique basé sur des fonctions mathématiques paramétriques, calcul d'un second modèle théorique obtenu par somme algébrique d'un terme correctif, ledit second modèle théorique comportant un jeu de paramètres, ledit jeu de paramètres comprenant à la fois les paramètres à déterminer qui décrivent la structure géométrique de l'échantillon d'intérêt et les paramètres déterminés selon la calibration décrite ci-dessus qui décrivent la réponse instrumentale ;
- détermination des paramètres présents dans le second modèle théorique et décrivant la structure de l'échantillon d'intérêt au moyen d'un ajustement entre ledit second modèle théorique et ladite image expérimentale.

## LISTE DES FIGURES

D'autres caractéristiques et avantages de l'invention ressortiront clairement de la description qui en est donnée ci-dessous, à titre indicatif et nullement limitatif, en référence aux figures annexées, parmi lesquelles :

- la figure 1 illustre schématiquement un profil d'intensité d'électrons secondaires en fonction du profil d'un motif obtenu via une instrumentation de type CD-SEM ;
- les figures 2a et 2b illustrent un exemple de modélisation mathématique paramétrique d'une image CD-SEM ;
- les figures 3a, 3b, 3c et 3d illustrent des exemples d'artefacts de type marques sombres observées sur des images CD-SEM expérimentales ;
- la figure 4 montre plusieurs images CD-SEM acquises sur le même échantillon mais avec un angle de balayage différent ;
- la figure 5 représente les différentes étapes du procédé selon l'invention ;
- la figure 6 illustre la méthode de balayage dite raster scan ou balayage TV.

## DESCRIPTION DETAILLEE

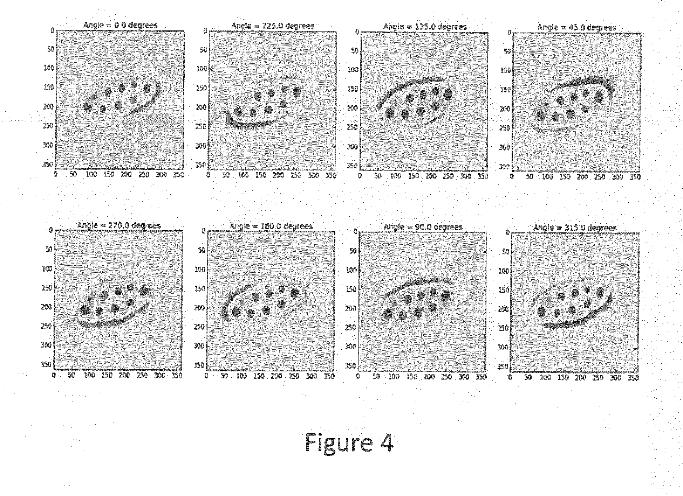

La figure 4 montre une série d'images CDSEM prises sur un même échantillon. Chaque image a été acquise en balayant la surface de l'échantillon suivant un angle différent. Il est évident qu'en variant l'angle de balayage, les images obtenues changent. Cela montre clairement que le parcours du faisceau a une influence sur le processus de formation de l'image : le signal mesuré à une position donnée sur l'échantillon change selon le parcours suivi par le faisceau d'électrons primaires.

Ces observations peuvent être expliquées en évoquant les effets de charging décrits plus haut, y compris les effets temporels.

Il apparaît nécessaire de modéliser le signal mesuré à une position donnée sur la surface de l'échantillon en prenant en compte les positions balayées par le faisceau d'électrons primaires avant d'arriver à la position donnée.

Lors de l'avancement du faisceau incident d'électrons primaires au point r sur l'échantillon, des électrons secondaires sont générés avec un rendement $\rho(r)$. Ce rendement est lié à la nature des matériaux présents au point r mais aussi à son voisinage et à la géométrie de la structure considérée.

De plus, le faisceau d'électrons primaires n'est pas ponctuel mais possède une distribution spatiale de densité de courant incident. Le rendement effectif lorsque le faisceau est centré sur le point P est :

$$R(P) = \iint \rho(r) \times f(r - P) dr$$

Où $f(r)$ est la distribution spatiale d'électrons normalisée. Cette fonction de distribution suit une loi décroissante, par exemple composée par des fonctions gaussiennes. Dans ce qui suit on considère que la contribution au point P est la contribution intégrée spatialement de la réponse sur l'extension spatiale du faisceau.

La réponse instantanée au point P est donc une résultante de plusieurs facteurs complexes. Lorsque les électrons rétrodiffusés et secondaires sont générés, ils créent une distribution de charges conduisant à l'apparition d'un champ électrostatique qui va modifier le signal détecté lors du déplacement du faisceau incident. Ces champs générés décroissent généralement si des processus de déchargement existent (champs électrostatiques extérieurs, évacuation de charges par l'échantillon, etc.). Cependant ce temps de déchargement est souvent plus grand que le temps caractéristique entre deux points de mesure du microscope, ce qui perturbe la formation de l'image.

La présente invention modélise l'effet de ces charges à l'aide d'un terme correctif S. Le rendement de création des charges est proportionnel à $R(r)$ et est fonction du matériau éclairé et de sa géométrie (et donc de la position). L'effet immédiat en r au temps t sur le signal est appelé $T(r, t) = I(t)R(r)C(r)$. Avec $C(r)$ traduisant un coefficient de charging effectif, où $I(t)$ est le courant lorsque le faisceau incident est en r.

L'effet des charges est dispersé spatialement avec une fonction de distribution $F_S(r)$. Cette distribution est maximale en r=0 et décroît avec la distance r.

L'effet des charges décroît avec le temps puisqu'on peut supposer qu'il existe des processus d'évacuation des charges qui ont une constante de temps caractéristique $\tau$. On prendra $F_t(t)$.

On considère en toute généralité que le faisceau incident suit une séquence de positions $r_p$ en fonction du temps $t_p$, où $p$ est un indice de position.

Le modèle tient compte du fait qu'il peut exister plusieurs temps tels que $P(t) = P(t')$ avec $t \neq t'$. Le balayage peut donc comporter des points redondants, ce qui existe, notamment lorsque les images sont accumulées sur plusieurs passes (frames).

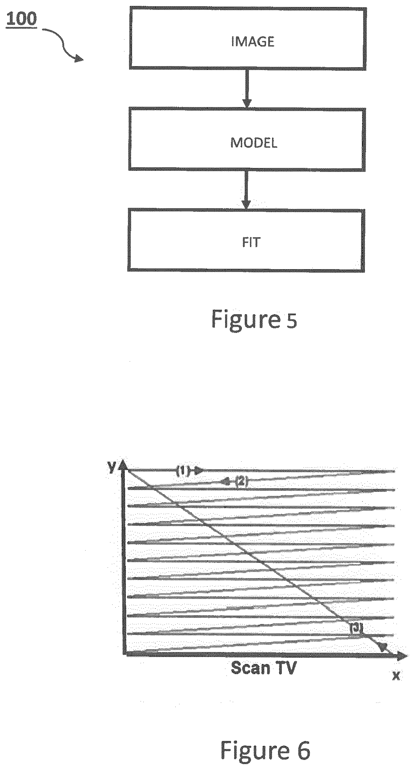

La figure 5 illustre les différentes étapes du procédé 100 selon l'invention.

La première étape IMAGE du procédé 100 selon l'invention comprend l'acquisition d'une image expérimentale représentative de la surface de l'échantillon et issue d'un microscope électronique à balayage.

Cette étape comprend par exemple le balayage de la portion d'échantillon d'intérêt avec le faisceau d'électrons primaires et la formation d'une image obtenue en mesurant les électrons secondaires émis.

La deuxième étape MODEL du procédé 100 selon l'invention comprend la modélisation du signal mesuré à l'aide d'un second modèle théorique $U(P_i, t_i)$ obtenu à partir d'un premier modèle paramétrique par somme d'un terme correctif $S(P_i, t_i)$. Le modèle $U(P_i, t_i)$ donne l'intensité du signal d'électrons secondaires à la position $P_i$ à l'instant $t_i$.

Le premier modèle théorique est construit à partir de fonctions mathématiques paramétriques et contient un jeu de paramètres décrivant la structure de l'échantillon ainsi que la réponse instrumentale. On peut considérer que le premier modèle théorique prend en compte la topographie de l'échantillon, la charge électrique déposée, le rendement de charge et les passages multiples du faisceau d'électrons primaires lors du balayage.

Le terme correctif prend en compte les charges en excès déposées par le faisceau d'électrons primaires lors du balayage. Ce terme correctif est construit en sommant les contributions provenant des charges déposées à chaque position lors du balayage du faisceau d'électrons primaires. Le terme correctif comprend une fonction de dispersion spatiale pour prendre en compte la topographie de l'échantillon. Le terme correctif comprend également une fonction de dispersion temporelle pour la prise en compte des phénomènes d'évacuation des charges. Le terme correctif prend en compte les éventuels passages multiples du faisceau d'électrons primaires.

La troisième étape FIT du procédé 100 selon l'invention comprend l'ajustement du modèle $U(P_i, t_i)$ sur l'image expérimentale acquise à la première étape. L'étape d'ajustement permet de trouver les valeurs des paramètres décrivant la géométrie de l'échantillon après avoir pris en compte les artefacts liés par exemple aux effets de charging.

Le terme correctif peut s'écrire au point $P_i$ à l'instant $t_i$ comme :

$$S(P_i, t_i) = \sum_{j=1}^{i} \delta(P_i - P_j) \left[ \sum_{k=1}^{j} C_k Q_k R_k F_S(P_j - P_k) F_t(t_j - t_k) \right]$$

L'indice $j \leq i$ balaye la séquence de positions $P_j$ du faisceau d'électrons primaires éclairées aux instants $t_j$, jusqu'à la position $P_i$ éclairé à l'instant $t_i$, le faisceau d'électrons primaires pouvant éclairer la même position à des instants différents.

La somme sur l'indice j relatif à la fonction delta de Kronecker prend en compte la possibilité de plusieurs passages du faisceau d'électrons primaires au point $P_i$ éclairé à l'instant $t_i$.

La somme sur l'indice k permet de calculer le terme correctif pour chaque passage du faisceau d'électrons primaires à la position $P_j$. Cette somme prend en compte les points $P_k$ balayés par le faisceau d'électrons primaires aux instants $t_k$ précédant l'instant $t_j$.

$Q_k$ est la charge déposée lorsque le faisceau est à la position $P_k$. Cette charge est fonction du courant mais aussi du temps pendant lequel on peut considérer que le faisceau est à la position $P_k$, c'est-à-dire de la vitesse de balayage. La quantité $R_k$ apparaît également dans le premier modèle théorique de la surface de l'échantillon et contient les paramètres décrivant la géométrie de l'échantillon ainsi que les paramètres décrivant la réponse instrumentale et le rendement de création de charge.

Le paramètre $C_k$ est un coefficient de charging effectif.

La fonction $F_S(r - P_k)$ est une fonction de dispersion spatiale et la fonction $F_t(t - t_k)$ est une fonction de dispersion temporelle.

Lorsque les phénomènes de charging sont négligés, le signal mesuré pendant la séquence est :

$$U(P_i, t_i) = \sum_{j=1}^{i} Q_j R_j \delta(P_i - P_j)$$

Le signal mesuré est une somme sur toutes les positions balayées par le faisceau d'électrons primaires. Le delta de Kronecker $\delta(P_i - P_j)$ est égal à un quand $P_i = P_j$ et zéro ailleurs. En effet, lorsque le faisceau éclaire la position $P_i$, le signal est enregistré dans le pixel $P_i$ du détecteur. Si le faisceau repasse sur le même point, le signal sera intégré (ajouté au précédent). Le détecteur a donc une mémoire.

Selon un mode de réalisation le second modèle théorique est obtenu selon la formule suivante :

$$U(P_i, t_i) = \left[\sum_{j=1}^{i} Q_j R_j \times \delta(P_i - P_j)\right] - S(P_i, t_i)$$

Le signe moins devant le terme correctif S vient du fait que le charging se traduit souvent par des zones plus sombres sur les images CDSEM, soit une atténuation du signal hors charging. Dans certains cas cependant, l'impact du charging peut être au contraire positif, selon le signe du coefficient effectif de charging.

Un avantage de ce mode de réalisation est de prendre en compte les effets de charging à la fois spatiaux et temporels. De plus, ce mode de réalisation prend en compte le fait que le faisceau d'électrons primaires peut passer plusieurs fois par la même position.

Le deuxième modèle théorique peut donc être mis sous la forme suivante :

$$U(P_i, t_i) = \sum_{j=1}^{i} \delta(P_i - P_j)\left[Q_j R_j - \sum_{k=1}^{j} Q_k R_k C_k F_s(P_j - P_k).F_t(t_j - t_k)\right]$$

La fonction de dispersion $F_t(t_j - t_k)$ prend en compte les phénomènes d'évacuation des charges qui causent une diminution des charges en excès déposées lors du passage du faisceau d'électrons primaires.

Selon un mode de réalisation, la fonction de dispersion temporelle prend la forme :

$$F_t(t) = e^{-\frac{t}{\tau}}$$

où $\tau$ est le temps caractéristique d'évacuation des charges.

Selon un autre mode de réalisation des décroissances plus lentes peuvent être prises en compte en utilisant une fonction de type distribution de Cauchy :

$$F_t(t) = \frac{1}{1 + \left(\frac{t}{\tau}\right)^2}$$

La fonction de dispersion spatiale permet de prendre en compte la distance entre la position $P_i$ à laquelle le second modèle théorique est calculé et la charge $Q_j$ à la position $P_j$.

Selon un mode de réalisation la fonction de dispersion spatiale peut avoir une forme en cloche de type gaussien :

$$F_s(r) = e^{-\frac{\|r\|^2}{2\sigma^2}}$$

D'autres fonctions de distribution spatiale peuvent être utilisées suivant par exemple le mode de balayage de la surface choisi. Des fonctions de distribution spatiale asymétriques peuvent également être choisies.

Dans la plupart des images CDSEM deux hypothèses simplificatrices peuvent être appliquées. La première hypothèse est que le courant d'électrons primaires est constant pendant le balayage et égal à $Q_0$. La deuxième hypothèse est que la surface de l'échantillon est balayée une seule fois, sans passages multiples du faisceau d'électrons primaires. La deuxième hypothèse correspond à l'absence de points redondants : la condition $P(t) = P(t')$ avec $t \neq t'$ n'est jamais vérifiée.

Le deuxième modèle théorique peut alors être calculé suivant la formule suivante :

$$U(P_i, t_i) = U_0(P_i, t_i) - Q_o \sum_{j=1}^{i} R_j C_j F_s(P_i - P_j).F_t(t_i - t_j)$$

dans laquelle $U_0(P_i, t_i) = Q_0 R_i$ est le signal obtenu à la position $P_i$ à l'instant $t_i$ sans prendre en compte les effets de charging.

Un avantage de ce mode de réalisation est d'obtenir une formule plus simple à implémenter au cours de l'étape FIT du procédé selon l'invention.

A cause des effets de charging, une image CDSEM acquise sur un échantillon sans topographie et avec un seul matériau n'est pas plate mais aura une intensité $U_b(P_i, t_i)$ donnée par la formule suivante :

$$U_b(P_i, t_i) = Q_0 R_0 \times \left[ 1 - \sum_{j=1}^{i} C_j \, F_s(P_i - P_j).F_t(t_i - t_j) \right]_o$$

Où $R_0$ est la réponse du substrat. SI l'on soustrait ce terme à l'image calculée selon le deuxième modèle théorique on obtient :

$$U(P_i, t_i) - U_b(P_i, t_i) \propto \left( R_i - R_0 - \sum_{j=1}^{i} (R_j C_j - R_0 C_0) \, F_s(P_i - P_j).F_t(t_i - t_j) \right)$$

Si les phénomènes de charging sont homogènes à la surface de l'échantillon on peut considérer que le paramètre effectif de charging a la même valeur à tout point de la surface de l'échantillon $C_i \approx C_0$ et on obtient :

$$U(P_i, t_i) - U_b(P_i, t_i) \propto \Delta_i - C_0 \sum_{j=1}^{i} \Delta_i \, F_s(P_i - P_j).F_t(t_i - t_j)$$

Où $\Delta_i = R_i - R_0$.

Un avantage de ce mode de mode de réalisation est d'obtenir une modélisation dans laquelle le fond a une réponse nulle et que seules les parties contrastées, c'est-à-dire donnant lieu à $R_p - R_0 \neq a$ induisent le phénomène de charging.

Un avantage de ce mode de réalisation est que le fond peut être soustrait par traitement d'images et le calcul du charging ne se fait que sur les parties structurées de l'échantillon.

Le balayage de la surface de l'échantillon pour l'acquisition d'une image CDSEM peut être réalisé suivant plusieurs méthodes. Une technique souvent utilisée est le balayage dit raster scan ou balayage TV illustré à la figure 6. Selon ce mode de balayage on peut identifier une direction de balayage rapide selon la direction x indiquée sur la figure 6 et une direction de balayage lente selon la direction y indiquée sur la figure 6. Selon cette méthode de balayage, l'acquisition des données a lieu seulement en correspondance des traits horizontaux, indiqués (1) sur la figure 6. Dans ce qui suit on se référera à la direction de balayage rapide, x sur la figure 6, comme à la direction de balayage du faisceau d'électrons primaires.

Quand cette méthode de balayage est utilisée, chaque ligne de l'image est balayée à vitesse constante et on a que :

$$t_i - t_j = \frac{x_i - x_j}{v_x}$$

Cela revient à écrire le second modèle théorique selon la formule suivante :

$$U(x_i, t_i) = Q_i R_i - \sum_{j=1}^{i} Q_j R_j . C_j \, F_s(x_i - x_j).F_t\left(\frac{x_i - x_j}{v_x}\right)$$

Si l'on exclut les passages multiples du faisceau d'électrons primaires, le calcul du second modèle théorique se résume à :

$$U(x_i, t_i) = Q_i R_i - \sum_{j=1}^{i} Q_j R_j . C_j F(x_i - x_j)$$

Où $F(x) = F_s(x) . F_t \left(\dfrac{x}{v_x}\right)$ . Cette formule correspond à un terme correctif de type produit de convolution tronqué avec la réponse instantanée T.

En d'autres termes, le terme correctif est un produit de convolution entre le premier modèle paramétrique et un noyau de convolution donné. Le produit de convolution est calculé sur les positions balayées par le faisceau d'électrons primaires avant d'arriver à la position $P_i$ à l'instant $t_i$ et permet de prendre en compte les charges déposées par le faisceau.

Le second modèle théorique peut être calculé aussi en variables continues utilisant la formule suivante :

$$U(x) - U_0(x) \propto R(x) - R_0 - \int_0^x v_x dx' \times [C(x')R(x') - C_0 R_0] F(x - x')$$

Un avantage de ce mode de réalisation est la simplification des étapes de calcul, l'intégration étant réalisée exclusivement sur une seule variable spatiale.

Un autre objet de l'invention est la réalisation d'une étape de calibration d'une technique CDSEM. Cette étape de calibration est réalisée afin de déterminer les paramètres présents dans le modèle et liés à la réponse instrumentale. Ces paramètres font partie du jeu de paramètres déjà présents dans le premier modèle théorique et ils prennent en compte, par exemple, le fait que le faisceau d'électrons primaires a une taille non nulle. Souvent la forme du faisceau d'électrons primaires est décrite comme un profil gaussien. Cette fonction gaussienne prenant en compte les caractéristiques du faisceau d'électrons primaires est appelée « point spread function » en anglais ou PSF. Les paramètres décrivant la réponse instrumentale, par exemple les paramètres de la fonction PSF, peuvent avantageusement être déterminés lors d'une étape préliminaire de calibration. La calibration est obtenue en réalisant un ajustement entre le second modèle théorique et l'image expérimentale d'un échantillon dont la structure est connue. Cela permet de fixer les paramètres géométriques lors de l'étape de calibration et d'obtenir de façon plus fiable les paramètres décrivant la réponse instrumentale. Les valeurs des paramètres décrivant la réponse instrumentale seront ensuite fixées lors de la mise en oeuvre de la technique CD-SEM pour la caractérisation d'une image expérimentale d'intérêt.

Un avantage de la réalisation de l'étape de calibration est de pouvoir déterminer de façon plus précise et fiable les paramètres décrivant la réponse instrumentale. Ensuite ces paramètres décrivant la réponse instrumentale seront fixés lors de la mise en oeuvre de la technique CD-SEM pour la caractérisation d'une image expérimentale d'intérêt, ce qui permet d'atteindre une détermination plus précise et fiable des paramètres décrivant la structure de l'échantillon et donc des dimensions critiques d'intérêt

Un autre objet de l'invention est un procédé de mise en oeuvre d'une technique de caractérisation CD-SEM comportant les étapes suivantes :

- réalisation d'une image expérimentale représentative de la structure de l'échantillon et issue d'un microscope électronique à balayage ;
- à partir d'un premier modèle théorique basé sur des fonctions mathématiques paramétriques, calcul d'un second modèle théorique obtenu par somme algébrique d'un terme correctif, ledit second modèle théorique comportant un jeu de paramètres, ledit jeu de paramètres comprenant à la fois les paramètres à déterminer qui décrivent la structure géométrique de l'échantillon d'intérêt et les paramètres déterminés selon la calibration ci-dessus qui décrivent la réponse instrumentale ;
- détermination des paramètres présents dans le second modèle théorique et décrivant la structure de l'échantillon d'intérêt au moyen d'un ajustement entre ledit second modèle théorique et ladite image expérimentale.

Avantageusement, ce procédé de mise en oeuvre d'une technique de caractérisation CD-SEM est particulièrement efficace. Grâce à ce procédé il est possible de réaliser une image CD-SEM d'un échantillon d'intérêt et de mesurer au moins une dimension critique de cet échantillon tout en prenant en compte la réponse instrumentale et les effets de charging.

**Revendications**

1.  Procédé (100) de mise en oeuvre d'une technique de caractérisation par microscopie électronique à balayage pour la détermination d'au moins une dimension critique de la structure d'un échantillon dans le domaine de la métrologie dimensionnelle, dite technique CD-SEM, ledit procédé comportant les étapes suivantes :

    - réalisation d'une image expérimentale représentative de la structure de l'échantillon et issue d'un microscope électronique à balayage ;
    - à partir d'un premier modèle théorique basé sur des fonctions mathématiques paramétriques, calcul d'un second modèle théorique $U(P_i, t_i)$ décrivant un signal mesuré lors de la réalisation de ladite image, le signal étant mesuré par un détecteur du microscope, à l'instant $t_i$, lorsqu'un faisceau d'électrons primaires éclaire la position $P_i$, ledit second modèle $U(P_i, t_i)$ étant obtenu par somme algébrique d'un terme correctif $S(P_i, t_i)$, ledit second modèle théorique étant paramétré par un jeu de paramètres à déterminer, le premier et second modèle théorique étant chacun une représentation mathématique de la structure de l'échantillon dans l'image expérimentale ;
    - détermination du jeu de paramètres présents dans le second modèle théorique au moyen d'un ajustement entre ledit second modèle théorique et ladite image expérimentale ;

    ledit procédé étant **caractérisé en ce que** ledit terme correctif $S(P_i, t_i)$ est calculé en sommant le signal provenant des charges électriques déposées par le faisceau d'électrons primaires lors d'une pluralité d'instants $t$ inférieurs ou égaux à $t_i$, le terme correctif étant obtenu comme un produit de convolution entre le premier modèle paramétrique et un noyau de convolution donné, qui contient une fonction de dispersion temporelle et une fonction de dispersion spatiale.

2.  Procédé (100) selon la revendication précédente **caractérisé en ce que** le second modèle théorique est calculé selon la formule suivante :

$$U(P_i, t_i) = \left[ \sum_{j=1}^{i} Q_j R_j \delta(P_i - P_j) \right] - S(P_i, t_i)$$

dans laquelle :

$U(P_i, t_i)$ est le second modèle théorique calculé en correspondance de la position $P_j$ sur la surface de l'échantillon à l'instant $t_i$ ;

l'indice $j \le i$ balaye la séquence de positions $P_j$ du faisceau d'électrons primaires éclairées aux instants $t_j$, jusqu'à la position $P_i$ éclairée à l'instant $t_i$, le faisceau d'électrons primaires pouvant éclairer la même position à des instants différents ;

$Q_j$ est la charge électrique déposée par le faisceau d'électrons primaires lorsque le faisceau éclaire la position $P_j$ ;

$R_j$ est la fonction mathématique paramétrique contenant les paramètres décrivant la topographie de l'échantillon et le rendement de création de charge à la position $P_j$ ;

$\delta(P_i - P_j)$ est un delta de Kronecker, qui est égal à un quand $P_i = P_j$ et zéro ailleurs ; $\sum_{j=1}^{i} Q_j R_j \delta(P_i - P_j)$ est le premier modèle théorique du signal mesuré à la position $P_i$ à l'instant ti et prend en compte la topographie de l'échantillon, la charge électrique déposée, le rendement de charge et les passages multiples du faisceau d'électrons primaires lors du balayage;

$$S(P_i, t_i) = \sum_{j=1}^{i} \delta(P_i - P_j) \left[ \sum_{k=1}^{j} C_k Q_k R_k F_S(P_j - P_k) F_t(t_j - t_k) \right]$$

est le terme correctif ;

$F_S(P_L - P_j)$ est une fonction de dispersion spatiale prenant en compte la distance entre la charge électrique à la position $P_j$ et la position $P_i$ ;

$F_t(t_i - t_j)$ est une fonction de dispersion temporelle prenant en compte l'écart temporel entre le dépôt de la charge électrique à la position $P_j$ à l'instant $t_j$ et la mesure du signal à la position $P_i$ à l'instant $t_i$ ;

$C_j$ est coefficient effectif d'accumulation de charges à la position $P_j$.

3. Procédé (100) selon la revendication précédente **caractérisé en ce que** le courant d'électrons primaires est constant et égale à $Q_0$, le faisceau d'électrons primaires éclaire chaque position $P_j$ une seule fois et le second modèle théorique est calculé selon la formule suivante :

$$U(P_i, t_i) = U_0(P_i, t_i) - Q_o \sum_{j=1}^{i} R_j C_j F_s(P_i - P_j).F_t(t_i - t_j)$$

dans laquelle $U_0(P_i, t_i) = Q_0 R_i$.

4. Procédé (100) selon la revendication précédente **caractérisé en ce que** la réponse de l'échantillon en absence de topographie est $R_0$ et l'intensité de fond $U_b(P_i, t_i)$ due à l'excès de charge est soustraite au second modèle théorique pour éliminer l'émission des régions non structurées de l'échantillon, l'intensité de fond étant calculée selon la formule suivante

$$U(P_i, t_i) - U_b(P_i, t_i) \propto \left( R_i - R_0 - \sum_{j=1}^{i} (R_j C_j - R_0 C_0) F_s(P_i - P_j).F_t(t_i - t_j) \right)$$

Dans laquelle $U_b(P_i, t_i) = Q_0 R_0 \left[ 1 - \sum_{j=1}^{i} C_j F_S(P_i - P_j) F_T(t_i - t_j) \right]$.

5. Procédé (100) selon l'une des revendications précédentes **caractérisé en ce que** le faisceau d'électrons primaires balaye la surface de l'échantillon suivant la méthode de balayage dite TV ou « raster scan » en anglais, la direction de balayage étant la direction horizontale ou axe x, la vitesse de balayage $v_x$ étant constante.

6. Procédé selon la revendication précédente (100) **caractérisé en ce que** le second modèle théorique est calculé selon la formule suivante :

$$U(x) - U_b(x) \propto \left[ R(x) - R_0 - \int_0^x (C(x')R(x') - C_0 R_0) v_x F(x - x') dx' \right]$$

dans laquelle :

x est la cordonnée spatiale dans la direction de balayage du faisceau d'électrons primaires ;
$U_b(x)$ est l'intensité de fond à la position x ;
$Q_0(x)$ est la charge déposée par le faisceau d'électrons primaires en correspondance de la position x ;
$F(x - x') = F_S(x - x') F_t\left(\frac{x-x\prime}{v_x}\right)$ contient la fonction de dispersion spatiale et la fonction de dispersion temporelle exprimée en fonction de la cordonné x, la vitesse de balayage $v_x$ étant constante.

7. Procédé (100) selon l'une quelconque des revendications précédentes **caractérisé en ce que** la fonction de dispersion temporelle est une fonction exponentielle avec constante de temps $\tau$ :

$$F_t(t) = e^{-\frac{t}{\tau}}$$

8. Procédé (100) selon l'une des revendications 1 à 5 **caractérisé en ce que** la fonction de dispersion temporelle est une fonction de type distribution de Cauchy:

$$F_t(t) = \frac{1}{1 + \left(\frac{t}{\tau}\right)^2}$$

**9.** Procédé (100) selon l'une quelconque des revendications précédentes **caractérisé en ce que** la fonction de dispersion spatiale est de la forme

$$F_S(r) = e^{-\frac{\|r\|^2}{2\sigma^2}}$$

**10.** Procédé selon l'une des revendications 1 à 9, ledit procédé étant mis en oeuvre pour une calibration de la technique de caractérisation CD-SEM, ladite calibration comportant les étapes suivantes :

- réalisation d'une image expérimentale représentative de la structure d'un échantillon de référence dont les dimensions géométriques sont connues, ladite image étant issue d'un microscope électronique à balayage
- à partir d'un premier modèle théorique basé sur des fonctions mathématiques paramétriques, calcul d'un second modèle théorique obtenu par somme algébrique d'un terme correctif, ledit second modèle théorique comportant un jeu de paramètres, ledit jeu de paramètres comprenant à la fois les paramètres connus qui décrivent la structure géométrique de l'échantillon de référence et les paramètres à déterminer qui décrivent la réponse instrumentale ;
- détermination des paramètres présents dans le second modèle théorique et décrivant la réponse instrumentale au moyen d'un ajustement entre ledit second modèle théorique et ladite image expérimentale représentative de la structure de l'échantillon de référence.

**11.** Procédé de mise en oeuvre d'une technique de caractérisation CD-SEM selon l'une des revendications 1 à 9 et la revendication précédente, ledit procédé comportant les étapes suivantes :

- réalisation d'une image expérimentale représentative de la structure de l'échantillon et issue d'un microscope électronique à balayage ;
- à partir d'un premier modèle théorique basé sur des fonctions mathématiques paramétriques, calcul d'un second modèle théorique obtenu par somme algébrique d'un terme correctif, ledit second modèle théorique comportant un jeu de paramètres, ledit jeu de paramètres comprenant à la fois les paramètres à déterminer qui décrivent la structure géométrique de l'échantillon d'intérêt et les paramètres déterminés selon la calibration selon la revendication précédente qui décrivent la réponse instrumentale ;
- détermination des paramètres présents dans le second modèle théorique et décrivant la structure de l'échantillon d'intérêt au moyen d'un ajustement entre ledit second modèle théorique et ladite image expérimentale.

**Patentansprüche**

**1.** Verfahren (100) zur Durchführung einer Charakterisierungstechnik mittels Rasterelektronenmikroskopie zur Bestimmung mindestens einer kritischen Dimension der Struktur einer Probe im Gebiet der dimensionalen Messtechnik, der sogenannten CD-SEM-Technik, wobei das Verfahren die folgenden Schritte umfasst:

- Erstellung eines experimentellen Bildes, das für die Struktur der Probe repräsentativ ist und unter Verwendung eines Rasterelektronenmikroskops erhalten wird;
- ausgehend von einem ersten theoretischen Modell, das auf parametrischen mathematischen Funktionen basiert, Berechnung eines zweiten theoretischen Modells $U(P_i, t_i)$, das ein bei der Erstellung des Bildes gemessenes Signal beschreibt, wobei das Signal von einem Detektor des Mikroskops zum Zeitpunkt $t_i$ gemessen wird, wenn ein Primärelektronenstrahl die Position $P_i$ beleuchtet, wobei das zweite Modell $U(P_i, t_i)$ durch Bilden einer algebraischen Summe einer Korrekturgröße $S(Pi, t_i)$ erhalten wird, wobei das zweite theoretische Modell durch einen Satz zu bestimmender Parameter parametriert wird, wobei das erste und das zweite theoretische Modell jeweils eine mathematische Darstellung der Struktur der Probe in dem experimentellen Bild sind;
- Bestimmung des Satzes von Parametern, die in dem zweiten theoretischen Modell vorhanden sind, mittels eines Abgleichs zwischen dem zweiten theoretischen Modell und dem experimentellen Bild;

wobei das Verfahren **dadurch gekennzeichnet ist, dass** die Korrekturgröße $S(P_i, t_i)$ durch Summieren des Signals aus den elektrischen Ladungen, die von dem Primärelektronenstrahl bei einer Vielzahl von Zeitpunkten t kleiner oder gleich $t_i$ abgeschieden werden, berechnet wird, wobei die Korrekturgröße als ein Faltungsprodukt zwischen dem ersten parametrischen Modell und einem gegebenen Faltungskern erhalten wird, der eine zeitliche Streuungsfunktion und eine räumliche Streuungsfunktion enthält.

2. Verfahren (100) nach dem vorhergehenden Anspruch, **dadurch gekennzeichnet, dass** das zweite theoretische Modell nach der folgenden Formel berechnet wird:

$$U(P_i, t_i) = \left[\sum_{j=1}^{i} Q_j R_j \delta(P_i - P_j)\right] - S(P_i, t_i)$$

in der:

$U(P_i, t_i)$ das zweite theoretische Modell ist, das entsprechend der Position $P_i$ auf der Probenoberfläche zum Zeitpunkt $t_i$ berechnet wird;

der Index $j \leq i$ die Folge von Positionen $P_j$ des Primärelektronenstrahls, die zu den Zeitpunkten $t_j$ beleuchtet werden, bis zur Position $P_i$, die zum Zeitpunkt $t_i$ beleuchtet wird, abtastet, wobei der Primärelektronenstrahl dieselbe Position zu verschiedenen Zeitpunkten beleuchten kann;

$Q_j$ die elektrische Ladung ist, die vom Primärelektronenstrahl abgeschieden wird, wenn der Strahl die Position $P_j$ beleuchtet;

$R_j$ die parametrische mathematische Funktion ist, die Parameter enthält, die die Topografie der Probe und den Wirkungsgrad der Ladungserzeugung an der Position $P_j$ beschreiben;

$\delta(P_i - P_j)$ ein Kronecker-Delta ist, welches gleich eins ist, wenn $P_i - P_j$ und andernfalls null ist;

$\sum_{j=1}^{i} Q_j R_j \delta(P_i - P_j)$ das erste theoretische Modell des an der Position $P_i$ zum Zeitpunkt $t_i$ gemessenen Signals ist und die Topografie der Probe, die abgeschiedene elektrische Ladung, den Wirkungsgrad der Ladung und die vielfachen Durchgänge des Primärelektronenstrahls während der Abtastung berücksichtigt;

$$S(P_i, t_i) = \sum_{j=1}^{i} \delta(P_i - P_j)\left[\sum_{k=1}^{j} C_k Q_k R_k F_S(P_j - P_k) F_t(t_j - t_k)\right]$$

die Korrekturgröße ist;

$F_s(P_i - P_j)$ eine räumliche Dispersionsfunktion ist, die den Abstand zwischen der elektrischen Ladung an der Position $P_j$ und der Position $P_i$ berücksichtigt;

$F_t(t_i - t_j)$ eine zeitliche Dispersionsfunktion ist, die die zeitliche Abweichung zwischen dem Abscheiden der elektrischen Ladung an der Position $P_j$ zum Zeitpunkt $t_j$ und der Messung des Signals an der Position $P_i$ zum Zeitpunkt $t_i$ berücksichtigt;

$C_j$ der effektive Koeffizient der Ladungsakkumulation an der Position $P_j$ ist.

3. Verfahren (100) nach dem vorhergehenden Anspruch, **dadurch gekennzeichnet, dass** der Primärelektronenstrom konstant und gleich $Q_0$ ist, der Primärelektronenstrahl jede Position $P_j$ nur einmal beleuchtet und das zweite theoretische Modell nach der folgenden Formel berechnet wird:

$$U(P_i, t_i) = U_0(P_i, t_i) - Q_o \sum_{j=1}^{i} R_j C_j F_s(P_i - P_j) . F_t(t_i - t_j)$$

in der $U_0(P_i, t_i) = Q_0 R_i$.

4. Verfahren (100) nach dem vorhergehenden Anspruch, **dadurch gekennzeichnet, dass** die Antwort der Probe in Abwesenheit einer Topographie $R_0$ ist und die durch den Ladungsüberschuss bedingte Hintergrundintensität $U_b(P_i, t_i)$ vom zweiten theoretischen Modell subtrahiert wird, um die Emission von nicht strukturierten Bereichen der Probe zu eliminieren, wobei die Hintergrundintensität nach der folgenden Formel berechnet wird:

$$U(P_i, t_i) - U_b(P_i, t_i) \propto \left( R_i - R_0 - \sum_{j=1}^{i} (R_j C_j - R_0 C_0) F_s(P_i - P_j).F_t(t_i - t_j) \right)$$

in der:

$$U_b(P_i, t_i) = Q_0 R_0 \left[ 1 - \sum_{j=1}^{i} C_j F_S(P_i - P_j) F_T(t_i - t_j) \right]$$

.

5. Verfahren (100) nach einem der vorhergehenden Ansprüche, **dadurch gekennzeichnet, dass** der Primärelektronenstrahl die Oberfläche der Probe nach der sogenannten TV-Abtastmethode oder englisch "raster scan" abtastet, wobei die Abtastrichtung die horizontale Richtung oder x-Achse ist und die Abtastgeschwindigkeit $v_\chi$ konstant ist.

6. Verfahren (100) nach dem vorhergehenden Anspruch, **dadurch gekennzeichnet, dass** das zweite theoretische Modell nach der folgenden Formel berechnet wird:

$$U(x) - U_b(x) \propto \left[ R(x) - R_0 - \int_0^x (C(x')R(x') - C_0 R_0) v_x F(x - x') dx' \right]$$

in der:

$\chi$ die Raumkoordinate in der Abtastrichtung des Primärelektronenstrahls ist;
$U_b(\chi)$ die Hintergrundintensität an der Position x ist;
$Q_0(\chi)$ die Ladung, die vom Primärelektronenstrahl entsprechend der x-Position abgeschieden wird, ist;

$$F(x - x') = F_S(x - x') F_t \left( \frac{x - x'}{v_x} \right)$$

die räumliche Dispersionsfunktion und die zeitliche Dispersionsfunktion enthält, die als Funktion der Koordinate x ausgedrückt wird, wobei die Abtastgeschwindigkeit $v_\chi$ konstant ist.

7. Verfahren (100) nach einem der vorhergehenden Ansprüche, **dadurch gekennzeichnet, dass** die zeitliche Dispersionsfunktion eine Exponentialfunktion mit der Zeitkonstante $\tau$ ist:

$$F_t(t) = e^{-\frac{t}{\tau}}$$

.

8. Verfahren (100) nach einem der Ansprüche 1 bis 5, **dadurch gekennzeichnet, dass** die zeitliche Dispersionsfunktion eine Funktion vom Typ Cauchy-Verteilung ist:

$$F_t(t) = \frac{1}{1 + \left( \frac{t}{\tau} \right)^2}$$

.

9. Verfahren (100) nach einem der vorhergehenden Ansprüche, **dadurch gekennzeichnet, dass** die räumliche Dispersionsfunktion die folgende Form hat:

$$F_s(r) = e^{-\frac{\|r\|^2}{2\sigma^2}}$$

.

**10.** Verfahren nach einem der Ansprüche 1 bis 9, wobei das Verfahren für eine Kalibrierung der CD-SEM-Charakterisierungstechnik durchgeführt wird und die Kalibrierung die folgenden Schritte umfasst:

- Erstellung eines experimentellen Bildes, das für die Struktur einer Referenzprobe repräsentativ ist, deren geometrische Abmessungen bekannt sind, wobei das Bild unter Verwendung eines Rasterelektronenmikroskops erhalten wird;
- ausgehend von einem ersten theoretischen Modell, das auf parametrischen mathematischen Funktionen basiert, Berechnung eines zweiten theoretischen Modells, das durch Bilden einer algebraischen Summe einer Korrekturgröße erhalten wird, wobei das zweite theoretische Modell einen Satz von Parametern enthält, wobei der Satz von Parametern sowohl die bekannten Parameter, die die geometrische Struktur der Referenzprobe beschreiben, als auch die zu bestimmenden Parameter umfasst, die die Instrumentenantwort beschreiben;
- Bestimmung der Parameter, die in dem zweiten theoretischen Modell vorhanden sind und die Instrumentenantwort beschreiben, mittels eines Abgleichs zwischen dem zweiten theoretischen Modell und dem experimentellen Bild, das für die Struktur der Referenzprobe repräsentativ ist.

**11.** Verfahren zur Durchführung einer CD-SEM-Charakterisierungstechnik nach einem der Ansprüche 1 bis 9 und dem vorhergehenden Anspruch, wobei das Verfahren die folgenden Schritte umfasst:

- Erstellung eines experimentellen Bildes, das für die Struktur der Probe repräsentativ ist und unter Verwendung eines Rasterelektronenmikroskops erhalten wird;
- ausgehend von einem ersten theoretischen Modell, das auf parametrischen mathematischen Funktionen basiert, Berechnung eines zweiten theoretischen Modells, das durch Bilden einer algebraischen Summe einer Korrekturgröße erhalten wird, wobei das zweite theoretische Modell einen Satz von Parametern enthält, wobei der Satz von Parametern sowohl die zu bestimmenden Parameter, die die geometrische Struktur der interessierenden Probe beschreiben, als auch die entsprechend der Kalibrierung nach dem vorhergehenden Anspruch bestimmten Parameter, die die Instrumentenantwort beschreiben, umfasst;
- Bestimmung der Parameter, die in dem zweiten theoretischen Modell vorhanden sind und die Struktur der interessierenden Probe beschreiben, mittels eines Abgleichs zwischen dem zweiten theoretischen Modell und dem experimentellen Bild.

## Claims

**1.** Method (100) for implementing a scanning electron microscopy characterisation technique for the determination of at least one critical dimension of the structure of a sample in the field of dimensional metrology, known as CD-SEM technique, said method comprising the following steps:

- producing an experimental image representative of the structure of the sample and derived from a scanning electron microscope;
- from a first theoretical model based on parametric mathematical functions, calculating a second theoretical model $U(P_i, t_i)$ describing a signal measured during producing of said image, the signal being measured by a detector of the microscope, at the instant $t_i$, when a primary electron beam illuminates the position $P_i$, said second model $U(P_i, t_i)$ being obtained by algebraic summation of a corrective term $S(P_i, t_i)$, said second theoretical model being parameterized by a set of parameters to be determined, first and second theoretical model being each a mathematical representation of the sample structure in the experimental image;
- determination of the set of parameters present in the second theoretical model by means of an adjustment between said second theoretical model and said experimental image;

said method being **characterised in that** said corrective term $S(P_i, t_i)$ is calculated by summing the signal originating from the electric charges deposited by the primary electron beam at a plurality of instants t less than or equal to $t_i$, the corrective term being obtained as a convolution product between the first parametric model and a given convolution kernel, which contains a temporal dispersion function and a spatial dispersion function.

**2.** Method (100) according to the preceding claim **characterised in that** the second theoretical model is calculated according to the following formula:

$$U(P_i, t_i) = \left[ \sum_{j=1}^{i} Q_j R_j \delta(P_i - P_j) \right] - S(P_i, t_i)$$

in which:

$U(P_i, t_i)$ is the second theoretical model calculated in correspondence with the position $P_i$ on the surface of the sample at the instant $t_i$;

the index $j \leq i$ scans the sequence of positions $P_j$ of the primary electron beam illuminated at the instants $t_j$, up to the position $P_i$ illuminated at the instant $t_i$, the primary electron beam being able to illuminate the same position at different instants;

$Q_j$ is the electric charge deposited by the primary electron beam when the beam illuminates the position $P_j$;

$R_j$ is the parametric mathematical function containing the parameters describing the topography of the sample and the charge creation efficiency at the position $P_j$;

$\delta(P_i - P_j)$ is a Kronecker delta, which is equal to one when $P_i = P_j$ and zero otherwise;

$\sum_{j=1}^{i} Q_j R_j \delta(P_i - P_j)$ is the first theoretical model of the signal measured at the position $P_i$ at the instant $t_i$ and takes into account the topography of the sample, the deposited electric charge, the charge efficiency and the multiple passages of the primary electron beam during scanning;

$S(P_i, t_i) = \sum_{j=1}^{i} \delta(P_i - P_j) \left[ \sum_{k=1}^{j} C_k Q_k R_k F_S(P_j - P_k) F_t(t_j - t_k) \right]$ is the corrective term;

$F_s(P_i - P_j)$ is a spatial dispersion function taking into account the distance between the electric charge at the position $P_j$ and the position $P_i$;

$F_t(t_i - t_j)$ is a temporal dispersion function taking into account the temporal difference between the deposition of the electric charge at the position $P_j$ at the instant $t_j$ and the measurement of the signal at the position $P_i$ at the instant $t_i$;

$C_j$ is the effective charge accumulation coefficient at the position $P_j$.

3. Method (100) according to the preceding claim **characterised in that** the current of primary electrons is constant and equal to $Q_0$, the primary electron beam illuminates each position $P_j$ a single time and the second theoretical model is calculated according to the following formula:

$$U(P_i, t_i) = U_0(P_i, t_i) - Q_o \sum_{j=1}^{i} R_j C_j F_s(P_i - P_j) . F_t(t_i - t_j)$$

in which $U_0(P_i, t_i) = Q_0 R_i$.

4. Method (100) according to the preceding claim **characterised in that** the response of the sample in the absence of topography is $R_0$ and the background intensity $U_b(P_i, t_i)$ due to the excess of charge is subtracted from the second theoretical model to eliminate the emission from non-structured regions of the sample, the background intensity being calculated according to the following formula

$$U(P_i, t_i) - U_b(P_i, t_i) \propto \left( R_i - R_0 - \sum_{j=1}^{i} (R_j C_j - R_0 C_0) F_s(P_i - P_j) . F_t(t_i - t_j) \right)$$

In which $U_b(P_i, t_i) = Q_0 R_0 \left[ 1 - \sum_{j=1}^{i} C_j F_S(P_i - P_j) F_T(t_i - t_j) \right]$.

5. Method (100) according to one of the preceding claims **characterised in that** the primary electron beam scans the surface of the sample according to the so-called TV or raster scan method, the scanning direction being the horizontal direction or x axis, the scanning speed $v_x$ being constant.

6. Method according to the preceding claim (100) **characterised in that** the second theoretical model is calculated according to the following formula:

$$U(x) - U_b(x) \propto \left[ R(x) - R_0 - \int_0^x (C(x')R(x') - C_0 R_0)v_x F(x - x')dx' \right]$$

in which:

x is the spatial coordinate in the scanning direction of the primary electron beam;
$U_b(x)$ is the background intensity at the position x;
$Q_0(x)$ is the charge deposited by the primary electron beam in correspondence with the position x;

$$F(x - x') = F_s(x - x')F_t\left(\frac{x-x'}{v_x}\right)$$ contains the spatial dispersion function and the temporal dispersion function expressed as a function of the coordinate x, the scanning speed $v_x$ being constant.

7. Method (100) according to any of the preceding claims **characterised in that** the temporal dispersion function is an exponential function with time constant $\tau$:

$$F_t(t) = e^{-\frac{t}{\tau}}$$

8. Method (100) according to one of claims 1 to 5 **characterised in that** the temporal dispersion function is a Cauchy type distribution function:

$$F_t(t) = \frac{1}{1 + \left(\frac{t}{\tau}\right)^2}$$

9. Method (100) according to any of the preceding claims **characterised in that** the spatial dispersion function is of the form:

$$F_s(r) = e^{-\frac{\|r\|^2}{2\sigma^2}}$$

10. Method according to one of claims 1 to 9, said method being implemented for a calibration of the CD-SEM characterisation technique, said calibration comprising the following steps:

- producing an experimental image representative of the structure of a reference sample of which the geometric dimensions are known, said image being derived from a scanning electron microscope
- from a first theoretical model based on parametric mathematical functions, calculating a second theoretical model obtained by algebraic summation of a corrective term, said second theoretical model comprising a set of parameters, said set of parameters including both the known parameters which describe the geometric structure of the reference sample and the parameters to be determined which describe the instrumental response;
- determining the parameters present in the second theoretical model and describing the instrumental response by means of an adjustment between said second theoretical model and said experimental image representative of the structure of the reference sample.

11. Method for implementing a CD-SEM characterisation technique according to one of claims 1 to 9 and the preceding claim, said method comprising the following steps:

- producing an experimental image representative of the structure of the sample and derived from a scanning electron microscope;
- from a first theoretical model based on parametric mathematical functions, calculating a second theoretical model obtained by algebraic summation of a corrective term, said second theoretical model comprising a set of parameters, said set of parameters including both the parameters to be determined which describe the geometric structure of the sample of interest and the parameters determined according to the calibration according to the preceding claim which describe the instrumental response;
- determining the parameters present in the second theoretical model and describing the structure of the sample of interest by means of an adjustment between said second theoretical model and said experimental image.

Fig. 1

Figure 2a

Figure 2b

Figure 3a

Figure 3b

Figure 3c

Figure 3d

Figure 4

100

**IMAGE**

**MODEL**

**FIT**

Figure 5

Scan TV

Figure 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2014041058 B

**Littérature non-brevet citée dans la description**

- **C. G. FRASE ; E. BUHR ; K. DIRSCHERL.** CD characterization of nanostructures in SEM metrology. *Meas. Sci. Technol.,* Février 2007, vol. 18 (2), 510
- **C. A. MACK ; B.D. BUNDAY.** Analytical Linescan Model for SEM Metrology. *Metrology, Inspection and Process Control for Microlitography XXIX, Proc. SPIE,* 2015, vol. 9424

- **SHIMON LEVIA ; ISHAI SCHWARZBANDA ; SERGEY KHRISTOA ; YAN IVANCHENKOA ; OFER ADANA.** SEM Simulation for 2D and 3D Inspection Metrology and Defect Review. *Applied Materials, Rehovot 76705, Israel*